# EUROPEAN PATENT APPLICATION

(11) **EP 3 486 613 A1**
(43) Date of publication of application: **22.05.2019**
(21) Application number: 18207110.0
(22) Date of filing: 19.11.2018
(51) Int. Cl.: G01D 3/08

(54) **IN-RANGE SENSOR FAULT DETECTION**

(30) Priority: 17.11.2017 US 201715817156
(71) Applicant: Pratt & Whitney Canada Corp., Longueuil, Québec J4G 1A1 (CA)
(72) Inventor: DAFTARI, Saadi, (01BE5) Longueuil, Québec J4G 1A1 (CA); WU, Hai, (01BE5) Longueuil, Québec J4G 1A1 (CA)
(74) Representative: Dehns

(57) **Abstract**

In a method for detecting in-range faults for a sensor (202) of an aircraft engine sensor control system (200), a plurality of in-range values produced by the sensor (202) are received. At least one rate reversal event, indicative of a variation in the rate-of-change of the plurality of in-range values exceeding a predetermined variance threshold, is detected. A count of rate reversal events during a predetermined time period is determined. A faulty status to the sensor (202) is assigned based on the count of rate reversal events exceeding a predetermined limit.

## Description

### TECHNICAL FIELD

The present disclosure relates generally to sensors, and more specifically to fault detection for sensors.

### BACKGROUND OF THE ART

Sensors find use in numerous applications, serving to provide information about environmental conditions, operating parameters, and the like. Sensors are used in all manner of vehicle, industrial machine, electric and electronic appliance, and are often used to provide information which can be used in feedback loops and control systems.

However, sensors occasionally fail. In some cases, when a sensor fails, it produces values which are outside an expected range for the sensor, and failure can be easily detected. However, in other cases a sensor may produce incorrect values which still lie within an expected range, referred to as "in-range" fault.

Thus, techniques for detecting in-range faults are needed.

### SUMMARY

In accordance an aspect of the present invention, there is provided a method for detecting in-range faults for a sensor of an aircraft engine control system, comprising: receiving a plurality of in-range values produced by the sensor; detecting at least one rate reversal event indicative of a variation in the rate-of-change of the plurality of in-range values exceeding a predetermined variance threshold; determining a count of rate reversal events during a predetermined time period; and assigning a faulty status to the sensor based on the count of rate reversal events exceeding a predetermined limit.

In some embodiments, assigning a faulty status to the sensor is further based on the at least one rate reversal event corresponding to a predetermined pattern.

In some embodiments, the limit is a number of rate reversals during the time period.

In some embodiments, the limit is a number of consecutive rate reversals.

In some embodiments, the number of consecutive rate reversals is at least 2.

In some embodiments, the limit is based on historical data acquired from the sensor.

In some embodiments, assigning a faulty status to the sensor comprises assigning a first faulty status indicative of a pending failure, the method further comprising, after assigning the first faulty status to the sensor: receiving a plurality of subsequent in-range values produced by the sensor; detecting at least one rate reversal event in the subsequent in-range values; determining a subsequent count of rate reversal events during a subsequent predetermined time period; and assigning a second faulty status to the sensor based on the subsequent count of rate reversal events exceeding a predetermined subsequent limit different from the limit, the second faulty status indicative of an actual failure.

In some embodiments, the time period and the subsequent time period overlap.

In some embodiments, the method further comprises, after assigning the faulty status to the sensor, performing signal accommodation for the sensor.

In some embodiments, the sensor is a virtual sensor.

In accordance with another aspect of the present invention, there is provided an aircraft engine sensor control system communicatively coupled to a sensor, comprising a processing unit and a non-transitory computer-readable memory communicatively coupled to the processing unit. The memory comprises computer-readable program instructions executable by the processing unit for receiving a plurality of in-range values produced by the sensor, detecting at least one rate reversal event indicative of a variation in the rate-of-change of the plurality of in-range values exceeding a predetermined variance threshold, determining a count of rate reversal events during a predetermined time period, and assigning a faulty status to the sensor based on the count of rate reversal events exceeding a predetermined limit.

In some embodiments, assigning a faulty status to the sensor is further based on the at least one rate reversal event corresponding to a predetermined pattern.

In some embodiments, the limit is a number of rate reversals during the time period.

In some embodiments, the limit is a number of consecutive rate reversals.

In some embodiments, the number of consecutive rate reversals is at least 2.

In some embodiments, the limit is based on historical data acquired from the sensor.

In some embodiments, assigning a faulty status to the sensor comprises assigning a first faulty status indicative of a pending failure, wherein the computer-readable program instructions are further executable by the processing unit for, after assigning the first faulty status to the sensor: receiving a plurality of subsequent in-range values produced by the sensor; detecting at least one rate reversal event in the subsequent in-range values; determining a subsequent count of rate reversal events during a subsequent predetermined time period; and assigning a second faulty status to the sensor based on the subsequent count of rate reversal events exceeding a predetermined subsequent limit different from the limit, the second faulty status indicative of an actual failure.

In some embodiments, the time period and the subsequent time period overlap.

In some embodiments, the computer-readable program instructions are further executable by the processing unit for, after assigning the faulty status to the sensor, performing signal accommodation for the sensor.

In some embodiments, the sensor is a virtual sensor.

### BRIEF DESCRIPTION OF THE DRAWINGS

Reference is now made to the accompanying figures in which:
Figure 1 is a schematic cross-sectional view of an example gas turbine engine;
Figure 2 is a block diagram of an example sensor control system;
Figure 3A is a graph showing example sensor values;
Figure 3B is a graph showing rates-of-change for the sensor values of Figure 3A;
Figure 4 is a block diagram of an example computer system for implementing part or all of the engine control system of Figure 2; and
Figure 5 is a flowchart illustrating an example method for controlling the engine of Figure 1, in accordance with an embodiment.

It will be noted that throughout the appended drawings, like features are identified by like reference numerals.

### DETAILED DESCRIPTION

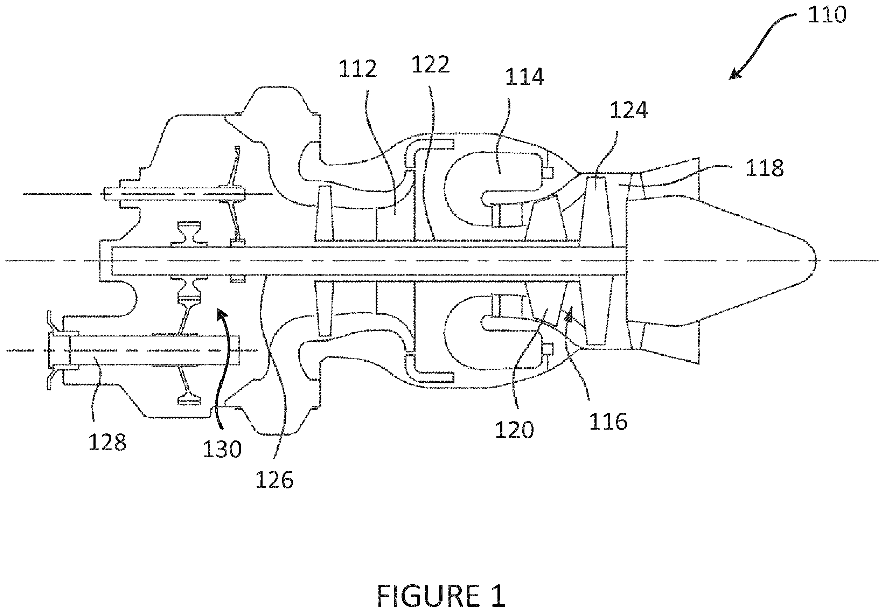

FIG. 1 illustrates a gas turbine engine 110 of a type preferably provided for use in subsonic flight, generally comprising in serial flow communication, a compressor section 112 for pressurizing the air, a combustor 114 in which the compressed air is mixed with fuel and ignited for generating an annular stream of hot combustion gases, and a turbine section 116 for extracting energy from the combustion gases. The combustion gases flowing out of the combustor 114 circulate through the turbine section 116 and are expelled through an exhaust duct 118. The turbine section 116 includes a compressor turbine 120 in driving engagement with the compressor section 112 through a high pressure shaft 122, and a power turbine 124 in driving engagement with a power shaft 126. The power shaft 126 is in driving engagement with an output shaft 128 through a gearbox 130, which may be a reduction gearbox. The engine 110 may be equipped with one or more sensors, which may measure pressure, temperature, speed, angular velocity, torque, and the like.

Although illustrated as a turboshaft engine, the gas turbine engine 110 may alternatively be another type of engine, for example a turbofan engine, also generally comprising in serial flow communication a compressor section, a combustor, and a turbine section, and a fan through which ambient air is propelled. A turboprop engine may also apply. In addition, although the sensor-related applications discussed herein pertain primarily to the engine 110 and flight applications, it should be understood that other uses, such as industrial, commercial, or the like, may apply.

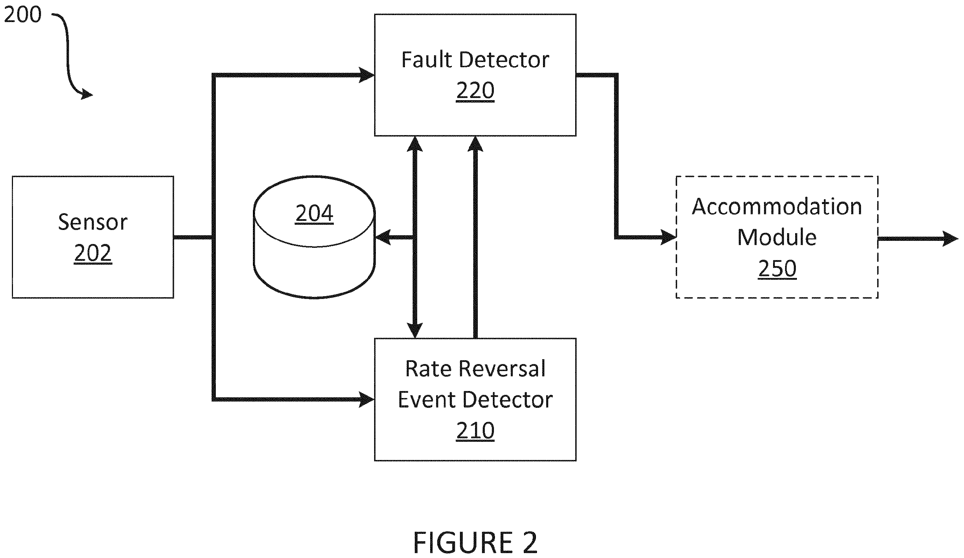

With reference to Figure 2, there is shown a sensor control system 200 which may be configured for detecting in-range sensor faults. The sensor control system 200 includes a sensor 202, a database 204, a rate reversal event (RRE) detector 210, a fault detector 220, and optionally includes an accommodation module 250. The sensor 202 may be any suitable kind of sensor, whether physical or virtual, and may provide values as analog signals, as digital signals, or as any suitable combination thereof. For example, the sensor is a temperature sensor, a pressure sensor, a speed or angular velocity sensor, a torque sensor, a power sensor, or any other suitable sensor.

The RRE detector 210 is configured for receiving the values produced by the sensor 202. In some embodiments, the RRE detector 210 is coupled to the sensor 202 via one or more wired and/or wireless connections. In other embodiments, the RRE detector 210 is provided with the values produced by the sensor 202 by a computing device or other architecture which governs the operation of the sensor 202. For example, the sensor 202 is a virtual sensor implemented in a computing device, and the RRE detector 210 is coupled to the computing device for obtaining the values produced by the sensor 202. In some embodiments, the RRE detector 210 is configured for receiving values from the sensor 202 which are both "in-range" and "out of range", but the RRE detector 210 analyzes only values from the sensor 202 which are "in-range", that is to say values which are with the normal operating range of the sensor 202. For example, the sensor 202 is a temperature sensor producing values which can normally range between 0°C and 50°C: the RRE detector 210 may receive all values, but only consider values between 0°C and 50°C for later analysis.

The RRE detector 210 is also configured for detecting at least one rate reversal event in the values received from the sensor 202. An RRE occurs when the rate-of-change of the values produced by the sensor varies beyond a predetermined variance threshold. Put differently, a RRE is indicated by a rapid fluctuation in the rate-of-change of the first derivative of the values produced by the sensor 202, i.e., variations in the second derivative of the values produced by the sensor 202. An RRE is only detected when the variation in the rate-of-change of the values is beyond a predetermined variance threshold. In some embodiments, the RRE detector 210 is preprogrammed with the variance threshold. In other embodiments, the RRE detector 210 acquires the variance threshold from the database 204, which may be any suitable storage device or medium. For example, the sensor 202 may operate in particularly extreme conditions, and different variance thresholds may be acceptable depending on the particular conditions to which the sensor 202 is exposed. For instance, different variance thresholds may be used depending on the ambient temperature in which the sensor 202 operates, or depending on any other ambient characteristic.

The RRE detector 210 may detect the RREs either digitally, for example by digitizing the values produced by the sensor 202 and inspecting the values, or via one or more analog means, for example using one or more differentiators. In some embodiments, the RRE detector 210 is configured for storing indications of RREs in the database 204.

The RRE detector 210 is also configured for determining a count of RREs during a predetermined time period. For example, the RRE detector 210 determines a count of RREs which take place during any 5 second interval, any 1 second interval, any 0.5 second interval, any 0.1 second interval, or any other suitable interval, appropriate for use with the sensor 202. The time period for evaluating a count of RREs may vary with the operating conditions of the sensor 202.

The RRE detector 210 is communicatively coupled to the fault detector 220 via any suitable wired and/or wireless means. The RRE detector 210 and/or the fault detector 220 are configured for assigning a faulty status to the sensor 202 based on the count of RREs exceeding a predetermined limit. The RRE detector 210 and/or the fault detector 220 may be preprogrammed with the predetermined limit, or may acquire the limit from the database 204.

In some embodiments, the limit is a number of RREs within the time period, and the RRE detector 210 and/or the fault detector 220 evaluates whether the count of RREs exceeds the number. For example, if more than two RREs occur within the time period of 1 second, the status of the sensor 202 is set to faulty. In other embodiments, the limit is a number of consecutive RREs, which are consecutive in terms of measurements or in terms of their occurrence in consecutive time periods. For example, if more than two RREs occur in three consecutive time periods, the status of the sensor 202 is set to faulty. In some other embodiments, the RRE detector 210 and/or the fault detector 220 determines whether the count of RREs corresponds to a predetermined pattern. For example, if RREs occur in every second time period, or every third time period, the status of the sensor 202 is set to faulty. It should be noted that the specific values used in the examples herein are merely examples, and other numerical values may be substituted therefor.

In some embodiments, the RRE detector 210 is configured for evaluating whether the count of RREs exceeds the limit and for reporting to the fault detector 220, which then assigns the faulty status to the sensor 202. In other embodiments, the RRE detector 210 provides the count of RREs to the fault detector 220, and the fault detector 220 evaluates whether the count exceeds the limit. In still further embodiments, the RRE detector 210 stores the count of RREs in the database 204, and the fault detector 220 acquires the count of RREs from the database 204 and evaluates whether to assign the faulty status to the sensor 202 based thereon.

In some embodiments, the faulty status of the sensor 202 is stored in the database 204 by the RRE detector 210 or by the fault detector 220. In other embodiments, the faulty status of the sensor is provided to another control system or entity, for example the accommodation module 250.

In some embodiments, the fault detector 220 is also configured for receiving the values produced by the sensor 202 for evaluating the presence of out-of-range faults, intermittent faults, open circuits, and the like. The fault detector 220 is provided with suitable hardware and software for evaluating other types of faults of the sensor 202, as appropriate.

In some embodiments, the RRE detector 210 and/or the fault detector 220 are provided with one or more profiles via the database 204, each of which is associated with a different sensor or type of sensor, and which indicates the relevant variance thresholds, time periods, and/or limits for the sensor. In some embodiments, a given sensor, for example the sensor 202, is provided with different profiles depending on the operating conditions of the sensor 202.

In some embodiments, one or more of the variance thresholds, time periods, and/or limits for the sensor 202 are based on historical data acquired from the sensor 202. For example, the limits against which the count of RREs is evaluated may be based on historical data acquired from other sensors like the sensor 202 to take into consideration sensor aging. In addition, historical data from the sensor 202 can be used to locate the sensor 202 on a sensor aging curve to select an appropriate profile. Still other applications for the historical data are considered.

The optional accommodation module 250 is configured for being informed of the faulty status of the sensor 202, for example via the fault detector 220, and for performing signal accommodation for the sensor 202. In some embodiments, signal accommodation is performed by finding and using an alternative source for the values produced by the sensor 202, for example another sensor separate from the sensor 202. In other embodiments, signal accommodation is performed by applying a smoothing function or other signal processing technique to the values produced by the sensor 202. For example, if the sensor 202 produces a signal with high noise or signal twitch, a smoothing function can be used to produce values with fewer fluctuations due to noise. In still other embodiments, signal accommodation is performed by using a default value for the sensor 202. Still other types of signal accommodation are considered.

In some embodiments, the sensor control system 200 is configured for evaluating sensors according to multiple tiers. When a first count of RREs during a first time period is found to exceed a first limit, the sensor 202 is assigned a first faulty status, for example a status indicative of a pending or forthcoming fault. Then, the values of the sensor 202 are evaluated to determine whether a subsequent count of RREs during a subsequent time period, which may be separate from the first time period or overlap therewith, exceeds a subsequent limit, at which point the sensor 202 is assigned a second faulty status, indicative of an actual failure of the sensor 202. The first and subsequent time periods, variance thresholds, limits, etc., may vary depending on the nature of the sensor 202. In addition, more than two different fault statuses are considered, and in some embodiments each faulty status is associated with a particular kind of signal accommodation.

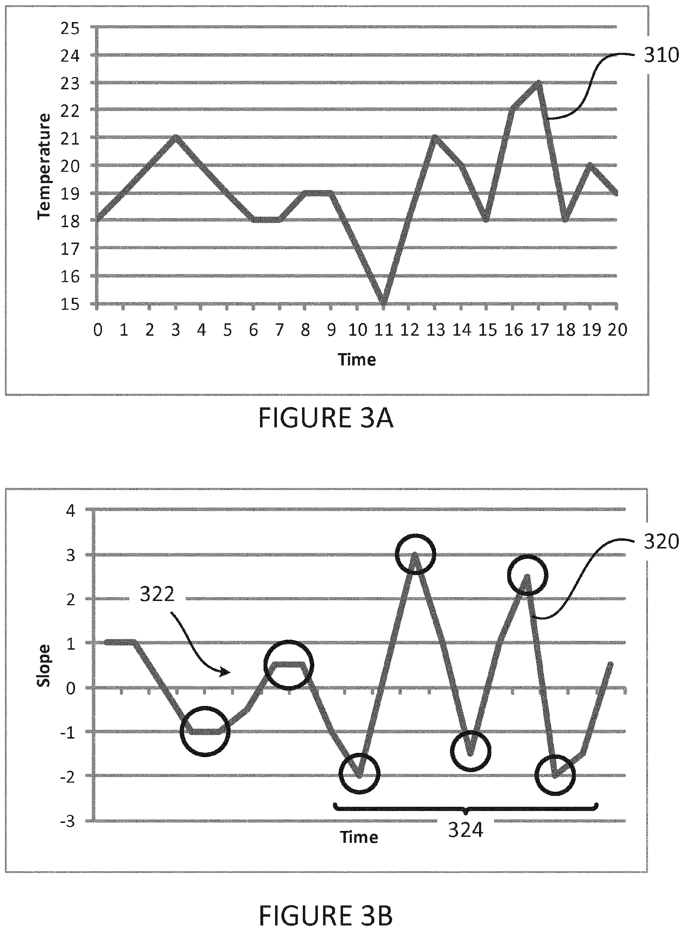

With reference to Figures 3A and 3B, there are shown example graphs of sensor values 310 and an associated first derivative 320 showing RREs, respectively. In the example of Figures 3A and 3B, the sensor 202 is a temperature sensor and the sensor values 310 can normally range between 0°C and 50°C. Although none of the sensor values 310 produced by the sensor 202 are outside the normal range of the sensor 202 (i.e. the sensor values are in-range), the sensor 202 is still faulty.

The graph of Figure 3B shows the first derivative 320 and RREs 322, surrounded by circles, which are variations in the first derivative 320. In addition, the portion 324 of the first derivative 320 indicates a time period during which the count of RREs is evaluated: during the time period 324, five RREs occur. If the limit is set at two RREs during any time period, then the occurrence of the five RREs during the time period 324 exceeds the limit, indicating that the sensor 202 is producing in-range faults. The sensor 202 is then assigned a faulty status.

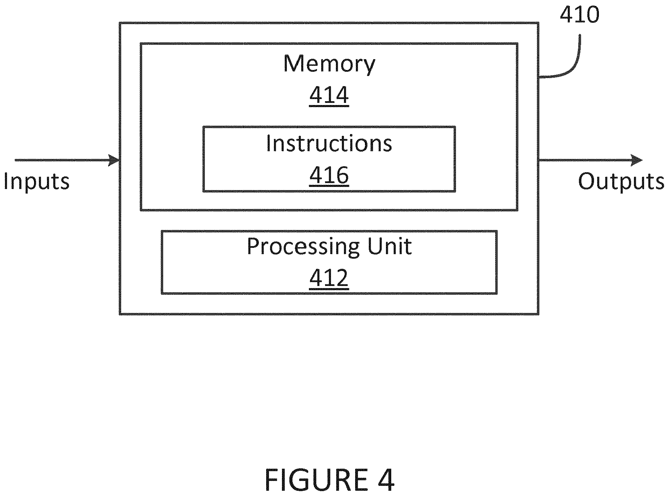

With reference to Figure 4, one or more components of the sensor control system 200, for instance the RRE detector 210 and/or the fault detector 220, may be implemented by a computing device 410, comprising a processing unit 412 and a memory 414 which has stored therein computer-executable instructions 416. For example, the RRE detector 210 and/or the fault detector 220 may be embodied as the computing device 410. The processing unit 412 may comprise any suitable devices configured to implement the RRE detector 210 and/or the fault detector 220 such that instructions 416, when executed by the computing device 410 or other programmable apparatus, may cause the functions/acts/steps performed as part of the RRE detector 210 and/or the fault detector 220 as described herein to be executed. The processing unit 412 may comprise, for example, any type of general-purpose microprocessor or microcontroller, a digital signal processing (DSP) processor, a central processing unit (CPU), an integrated circuit, a field programmable gate array (FPGA), a reconfigurable processor, other suitably programmed or programmable logic circuits, or any combination thereof.

The memory 414 may comprise any suitable known or other machine-readable storage medium. The memory 414 may comprise non-transitory computer readable storage medium, for example, but not limited to, an electronic, magnetic, optical, electromagnetic, infrared, or semiconductor system, apparatus, or device, or any suitable combination of the foregoing. The memory 414 may include a suitable combination of any type of computer memory that is located either internally or externally to device, for example random-access memory (RAM), read-only memory (ROM), compact disc read-only memory (CDROM), electro-optical memory, magnetooptical memory, erasable programmable read-only memory (EPROM), and electrically-erasable programmable read-only memory (EEPROM), Ferroelectric RAM (FRAM) or the like. Memory 414 may comprise any storage means (e.g., devices) suitable for retrievably storing machine-readable instructions 416 executable by processing unit 412.

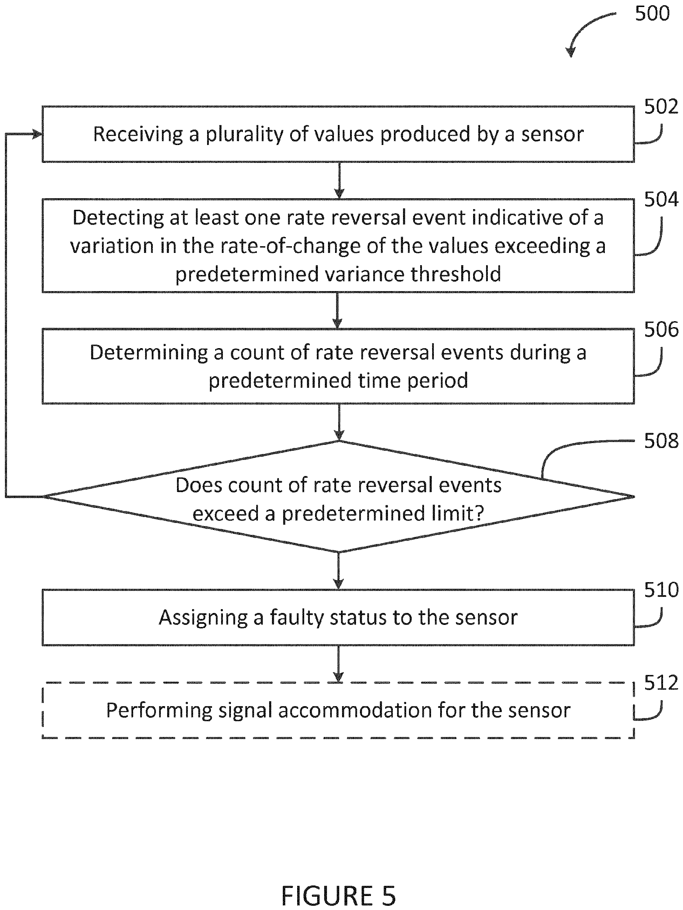

With reference to Figure 5, there is shown a method 500 for detecting in-range faults for a sensor, for example the sensor 202. At step 502, a plurality of values produced by the sensor 202 are received. The values may be received over one or more wired connections, one or more wireless connections, or any suitable combination thereof.

At step 504, at least one RRE, indicative of a variation in the rate-of-change of the values exceeding a predetermined variance threshold, is detected. At step 506, a count of RREs during a predetermined time period is determined. The variance threshold and the time period can be selected based on the nature of the sensor 202, the operating conditions of the sensor 202, or any other suitable conditions.

At decision step 508, a determination is made regarding whether the count of rate reversal events exceeds a predetermined limit. If the count of rate reversal events does not exceed the predetermined limit, the method 500 returns to some previous step, for example step 502. If the count of rate reversal events does exceed the predetermined limit, the method 500 proceeds to step 510.

At step 510, a faulty status is assigned to the sensor 202, for example based on the count of rate reversal events exceeding a predetermined limit. In some embodiments the limit is associated with the time period, and in other embodiments the limit relates to a predetermined pattern of RREs or a number of consecutive RREs.

Optionally, at step 512, signal accommodation is performed for the sensor 202. In some embodiments, an alternative healthy sensor is found and used. In other embodiments, a smoothing function or other signal processing algorithm is applied to the sensor 202. Still other types of signal accommodation are considered.

The methods and systems for detecting in-range faults for a sensor described herein may be implemented in a high level procedural or object oriented programming or scripting language, or a combination thereof, to communicate with or assist in the operation of a computer system, for example the computing device 410. Alternatively, the methods and systems described herein may be implemented in assembly or machine language. The language may be a compiled or interpreted language. Program code for implementing the methods and systems described herein may be stored on a storage media or a device, for example a ROM, a magnetic disk, an optical disc, a flash drive, or any other suitable storage media or device. The program code may be readable by a general or special-purpose programmable computer for configuring and operating the computer when the storage media or device is read by the computer to perform the procedures described herein. Embodiments of the methods and systems described herein may also be considered to be implemented by way of a non-transitory computer-readable storage medium having a computer program stored thereon. The computer program may comprise computer-readable instructions which cause a computer, or more specifically the processing unit 412 of the computing device 410, to operate in a specific and predefined manner to perform the functions described herein, for example those described in the method 500.

Computer-executable instructions may be in many forms, including program modules, executed by one or more computers or other devices. Generally, program modules include routines, programs, objects, components, data structures, etc., that perform particular tasks or implement particular abstract data types. Typically the functionality of the program modules may be combined or distributed as desired in various embodiments.

The above description is meant to be exemplary only, and one skilled in the art will recognize that changes may be made to the embodiments described without departing from the scope of the invention disclosed. Still other modifications which fall within the scope of the present invention will be apparent to those skilled in the art, in light of a review of this disclosure.

Various aspects of the methods and systems described herein may be used alone, in combination, or in a variety of arrangements not specifically discussed in the embodiments described in the foregoing and is therefore not limited in its application to the details and arrangement of components set forth in the foregoing description or illustrated in the drawings. For example, aspects described in one embodiment may be combined in any manner with aspects described in other embodiments. Although particular embodiments have been shown and described, it will be apparent to those skilled in the art that changes and modifications may be made without departing from this invention in its broader aspects. The scope of the following claims should not be limited by the embodiments set forth in the examples, but should be given the broadest reasonable interpretation consistent with the description as a whole.

## Claims

1. A method (500) for detecting in-range faults for a sensor (202) of an aircraft engine sensor control system (200), comprising:
receiving a plurality of in-range values produced by the sensor (202);
detecting at least one rate reversal event indicative of a variation in the rate-of-change of the plurality of in-range values exceeding a predetermined variance threshold;
determining a count of rate reversal events during a predetermined time period; and
assigning a faulty status to the sensor (202) based on the count of rate reversal events exceeding a predetermined limit.

2. The method of claim 1, wherein assigning a faulty status to the sensor (202) is further based on the at least one rate reversal event corresponding to a predetermined pattern.

3. The method of claim 1 or 2, wherein the limit is a number of rate reversals during the time period.

4. The method of claim 1 or 2, wherein the limit is a number of consecutive rate reversals, and preferably wherein the number of consecutive rate reversals is at least 2.

5. The method of claim 1 or 2, wherein the limit is based on historical data acquired from the sensor (202).

6. The method of any preceding claim, wherein assigning a faulty status to the sensor (202) comprises assigning a first faulty status indicative of a pending failure, further comprising, after assigning the first faulty status to the sensor (202):
receiving a plurality of subsequent in-range values produced by the sensor (202);
detecting at least one rate reversal event in the subsequent in-range values;
determining a subsequent count of rate reversal events during a subsequent predetermined time period; and
assigning a second faulty status to the sensor (202) based on the subsequent count of rate reversal events exceeding a predetermined subsequent limit different from the limit, the second faulty status indicative of an actual failure,
preferably wherein the time period and the subsequent time period overlap.

7. The method of any preceding claim, further comprising, after assigning the faulty status to the sensor (202), performing signal accommodation for the sensor (202).

8. An aircraft engine sensor control system (200) communicatively coupled to a sensor (202), comprising:
a processing unit (412); and
a non-transitory computer-readable memory (414) communicatively coupled to the processing unit (412) and comprising computer-readable program instructions (416) executable by the processing unit (412) for:
receiving a plurality of in-range values produced by the sensor (202);
detecting at least one rate reversal event indicative of a variation in the rate-of-change of the plurality of in-range values exceeding a predetermined variance threshold;
determining a count of rate reversal events during a predetermined time period; and
assigning a faulty status to the sensor (202) based on the count of rate reversal events exceeding a predetermined limit.

9. The system of claim 8, wherein assigning a faulty status to the sensor (202) is further based on the at least one rate reversal event corresponding to a predetermined pattern.

10. The system of claim 8 or 9, wherein the limit is a number of rate reversals during the time period.

11. The system of claim 8 or 9, wherein the limit is a number of consecutive rate reversals, and preferably wherein the number of consecutive rate reversals is at least 2.

12. The system of claim 8 or 9, wherein the limit is based on historical data acquired from the sensor (202).

13. The system of any of claims 8 to 12, wherein assigning a faulty status to the sensor (202) comprises assigning a first faulty status indicative of a pending failure, wherein the computer-readable program instructions (416) are further executable by the processing unit (412) for, after assigning the first faulty status to the sensor (202):
receiving a plurality of subsequent in-range values produced by the sensor (202);
detecting at least one rate reversal event in the subsequent in-range values;
determining a subsequent count of rate reversal events during a subsequent predetermined time period; and
assigning a second faulty status to the sensor (202) based on the subsequent count of rate reversal events exceeding a predetermined subsequent limit different from the limit, the second faulty status indicative of an actual failure,
preferably wherein the time period and the subsequent time period overlap.

14. The system of any of claims 8 to 13, wherein the computer-readable program instructions (416) are further executable by the processing unit (412) for, after assigning the faulty status to the sensor (202), performing signal accommodation for the sensor (202).

15. The system of any of claims 8 to 14, wherein the sensor (202) is a virtual sensor (202).
